(19) Europäisches Patentamt
European Patent Office
Office européen des brevets

(11) **EP 1 660 894 B1**

(12) **FASCICULE DE BREVET EUROPEEN**

(45) Date de publication et mention de la délivrance du brevet:
**23.07.2014 Bulletin 2014/30**

(21) Numéro de dépôt: **04786309.7**

(22) Date de dépôt: **13.08.2004**

(51) Int Cl.:
***G01R 29/08*** ^(2006.01)

(86) Numéro de dépôt international:
**PCT/FR2004/002140**

(87) Numéro de publication internationale:
**WO 2005/019842 (03.03.2005 Gazette 2005/09)**

(54) **DISPOSITIF ET PROCEDE POUR LA DETERMINATION D'AU MOINS UNE GRANDEUR ASSOCIEE AU RAYONNEMENT ELECTROMAGNETIQUE D'UN OBJET SOUS TEST**

VORRICHTUNG UND VERFAHREN ZUM BESTIMMEN VON MINDESTENS EINER KENNGRÖSSE DER ELETROMAGNETISCHEN STRAHLUNG EINES PRÜFOBJEKTES

DEVICE AND METHOD FOR DETERMINING AT LEAST ONE VARIABLE ASSOCIATED WITH THE ELECTROMAGNETIC RADIATION OF AN OBJECT BEING TESTED

(84) Etats contractants désignés:
**AT BE BG CH CY CZ DE DK EE ES FI FR GB GR HU IE IT LI LU MC NL PL PT RO SE SI SK TR**

(30) Priorité: **14.08.2003 FR 0309951**

(43) Date de publication de la demande:
**31.05.2006 Bulletin 2006/22**

(73) Titulaire: **Microwave Vision**
**91140 Villebon Sur Yvette (FR)**

(72) Inventeurs:
* **GARREAU, Philippe**
  **F-91540 Mennecy (FR)**
* **DUCHESNE, Luc**
  **F-91470 Angervilliers (FR)**
* **IVERSEN, Per Olav**
  **Marietta, GA 30068 (US)**
* **GANDOIS, Arnaud**
  **F-91650 Breux Jouy (FR)**

(74) Mandataire: **Regimbeau**
**20, rue de Chazelles**
**75847 Paris Cedex 17 (FR)**

(56) Documents cités:
**FR-A- 2 797 327**

* **FOURESTIE BENOIT ET AL: "A novel near-field measurement facility for random emissions" 2001 INTERNATIONAL SYMPOSIUM ON ELECTROMAGNETIC COMPATIBILITY; MONTREALM, QUE., CANADA AUG 13-17 2001, vol. 1, 2001, pages 378-382, XP002272390 IEEE Int Symp Electromagn Compat;IEEE International Symposium on Electromagnetic Compatibility 2001**
* **RUOSS H O ET AL: "EMC-INVESTIGATION OF HAND-HELD MOBILE TELEPHONES USING A DOUBLE- CONE NEARFIELD TO FARFIELD TRANSFORMATION" PROCEEDINGS OF THE 26TH. EUROPEAN MICROWAVE CONFERENCE 1996. PRAGUE, SEPT. 9 - 13, 1996, PROCEEDINGS OF THE EUROPEAN MICROWAVE CONFERENCE, SWANLEY, NEXUS MEDIA, GB, vol. VOL. 2 CONF. 26, 9 septembre 1996 (1996-09-09), pages 795-798, XP000682639 ISBN: 1-899919-08-2**

EP 1 660 894 B1

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

L'invention concerne des dispositifs et procédés pour la détermination d'au moins une grandeur associée au rayonnement électromagnétique d'un objet sous test.

Il a déjà été proposé, pour déterminer le diagramme de rayonnement d'un objet sous test, d'utiliser des dispositifs qui se présentent sous la forme d'un réseau de sondes réparties sur une arche entourant l'objet sous test à étudier (réseau circulaire).

On connaît notamment des dispositifs de ce type qui comportent des moyens qui permettent à l'arche de sondes et à l'objet sous test de tourner l'un par rapport à l'autre autour d'un axe qui correspond à un diamètre de l'arche. Généralement, c'est l'objet sous test qui tourne sur lui-même autour d'un axe vertical qui correspond au diamètre de l'arche, mais il peut être envisagé en variante que ce soit l'arche de sondes qui tourne sur elle-même, tandis que l'objet sous test est fixe.

On connaît notamment du document FR 2797327 un dispositif de test comprenant un appareil sous test disposé sur un plateau monté en rotation autour de son axe, un bras rotatif solidaire du plateau, et une arche circulaire fixe comprenant des capteurs.

On connaît également du document "EMC - investigation of hand-held mobile telephones using a double-cone nearfield to farfield transformation" par RUOSS et al. (Proceedings of the European Microwave Conference, GB, Swanley, Nexus Media, vol. Conf 26, 1996, pp 795-798) des dispositifs de mesure en champ proche selon des géométries de mesure sphérique, cylindrique ou conique.

De cette façon, le réseau de sondes mesure le rayonnement de l'objet sous test dans des plans successifs répartis autour de l'axe de rotation relatif de l'arche et de l'objet sous test. Au final, les mesures sont donc effectuées sur une sphère entourant totalement l'objet sous test.

Il est également connu d'utiliser des réseaux de sondes en arche en déplaçant de façon relative l'objet sous test perpendiculairement par rapport au plan du réseau de sondes de façon à mesurer ainsi le rayonnement sur un cylindre entourant l'objet.

Les dispositifs à réseau de sondes en arche présentent toutefois, qu'ils soient utilisés pour des mesures en coordonnées sphériques ou des mesures en coordonnées cylindriques, des limitations liées au pas de mesure discrétisé imposé par la disposition des sondes en réseau.

Contrairement, en effet, au cas d'une sonde unique qui peut être déplacée de façon continue, l'utilisation d'un réseau de sondes impose des contraintes aux dimensions de l'objet sous test dont on veut mesurer le champ.

En particulier, conformément à des théories bien connues dans le domaine du champ proche, le nombre de points d'échantillonnage est lié à la dimension électrique de l'objet sous test.

On pourra à cet égard se référer à :

Hansen, J. E., Editor (1988) Spherical Near-Field Antenna Measurements, London: Peregrines

Notamment, le nombre de points d'échantillonnage est fonction du rayon R de la sphère minimale ou du cylindre minimal englobant l'objet sous test et vérifie :

$$N \approx (2\Pi R / \lambda) + n \text{ Avec } n \approx 10$$

Par conséquent, on comprend qu'un réseau de N sondes ne permet que l'analyse d'objets compris dans une sphère ou dans un cylindre de rayon maximum R.

En d'autres termes, pour une fréquence ou une longueur d'onde d'analyse donnée et pour un réseau de sondes donné, il existe une taille maximum d'objets susceptibles d'être analysés.

Un but de l'invention est de pallier cet inconvénient et de permettre de relaxer cette contrainte pour élargir le domaine d'utilisation d'un réseau donné, notamment en termes de taille d'objet sous test ou de gamme de fréquence ou de longueur d'onde pour lesquelles il est susceptible d'être analysé.

L'invention est définit par l'objet des revendications 1 et 9.

Ce but est atteint selon l'invention grâce à un dispositif pour la détermination d'au moins une caractéristique de rayonnement électromagnétique d'un objet sous test comprenant un support destiné à recevoir ledit objet et un réseau de sondes réparti sur une arche sensiblement circulaire, caractérisé en ce qu'il comporte des moyens autorisant le basculement relatif du réseau de sondes et du support, dans le plan du réseau de sondes ou parallèlement à celui-ci, pour décaler angulairement l'un par rapport à l'autre le réseau de sondes et le support, et permettre ainsi des mesures selon plusieurs positions angulaires relatives du réseau de sondes et de l'objet sous test.

Avec un tel dispositif, il est possible de décaler angulairement le réseau de sondes par rapport au support, fournissant par la même occasion au moins une seconde série de mesures. On multiplie de cette façon, pour chaque plan, le nombre de points échantillonnés, sans multiplier le matériel nécessaire.

Les points obtenus au cours de plusieurs séries de mesure successives sont ensuite recombinés pour former un maillage plus dense que celui permis par le réseau circulaire de sondes.

D'autres caractéristiques, buts et avantages de l'invention apparaîtront à la lecture de la description détaillée qui va suivre, laquelle est purement illustrative et non limitative et doit être lue en regard des dessins annexés sur lesquels :

- la figure 1 est une représentation schématique d'un mode de réalisation possible de l'invention ;
- la figure 2 est une représentation schématique d'un autre mode de réalisation possible de l'invention ;

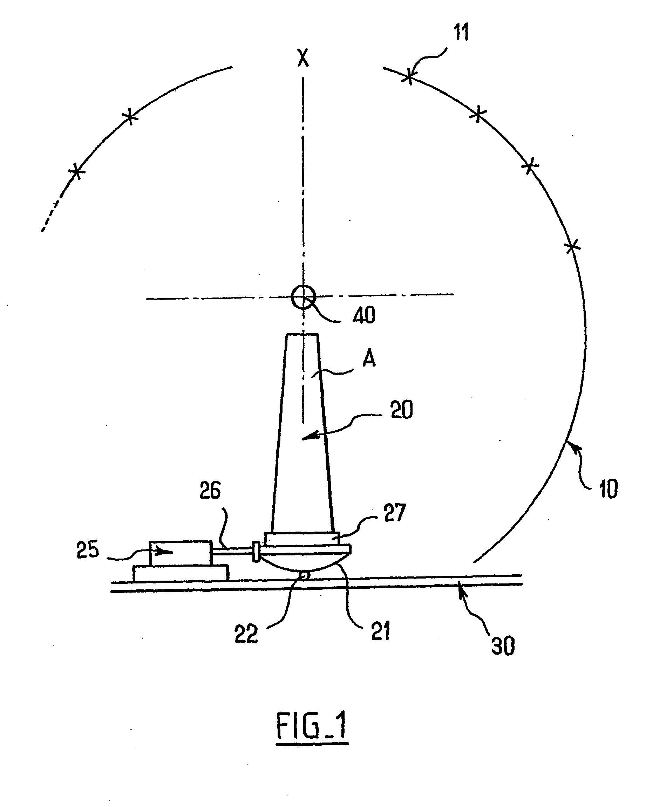

On a représenté sur la figure 1 une arche 10 comportant une pluralité de sondes électromagnétiques (ou antennes de mesure) 11 représentées schématiquement par des croix, ainsi qu'un support 20 destiné à porter l'objet dont on cherche à connaître le comportement électromagnétique (téléphone portable par exemple).

Ce support 20 est essentiellement un mât qui s'étend depuis le sol 30 jusqu'à proximité du centre géométrique de l'arche. Ce centre géométrique est mis en évidence sur la figure 1 par un cercle 40.

L'arche 10 est fixe par rapport au sol, tandis que le mât que constitue le support 20 est entraîné en rotation autour de son axe principal, lequel est référencé par A sur la figure 1.

Des moyens d'entraînement 27 de type à engrenage sont à cet effet prévus au niveau du socle du mât.

Il est par ailleurs prévu des moyens qui permettent de faire basculer le socle du mât 20 et de légèrement faire pivoter ce dernier et, en conséquence, l'objet sous test autour du centre 40.

Ce pivotement permet de décaler angulairement l'axe A par rapport au réseau de sondes et de balayer plusieurs positions relatives de l'axe A et de l'objet sous test par rapport au réseau de sondes.

Ainsi, pour chaque plan de mesure, c'est-à-dire pour chaque position pour lesquelles on fige le mât 20 dans sa rotation autour de son axe 20, il est possible d'effectuer plusieurs relevés consécutifs correspondant à différents décalages angulaires relatifs du réseau des sondes par rapport à l'axe A et à l'objet sous test.

Ce basculement du mât 20 dans le plan de l'arche permet donc de multiplier les points de mesure électromagnétique autour de l'objet sous test et de réaliser, avec un réseau de sondes de pas donné, un échantillonnage avec un pas inférieur au pas du réseau de sondes, par exemple avec un pas angulaire qui est une fraction du pas du réseau de sondes.

Les moyens de basculement sont par exemple avantageusement choisis pour balayer angulairement au moins l'ensemble du pas angulaire entre deux sondes.

Dans l'exemple illustré sur la figure 1, ces moyens comportent un moteur électrique 25 qui entraîne un vérin 26.

Ce vérin s'étend de façon sensiblement horizontale, dans le plan de l'arche et est articulé à une extrémité du socle. Le déplacement de ce vérin permet de basculer le mât 20 en lui conférant sensiblement un mouvement de pivotement centré sur le centre 40 de l'arche.

Pour autoriser ce basculement, le socle du mât 20 est muni d'une surface inférieure 21 convexe, qui prend appui, par l'intermédiaire d'un ou plusieurs rouleaux 22, sur une surface concave complémentaire (non représentée) sur laquelle elle roule lorsque le vérin est actionné.

Les formes complémentaires concave et convexe sont choisies pour permettre le mouvement de basculement/pivotement souhaité.

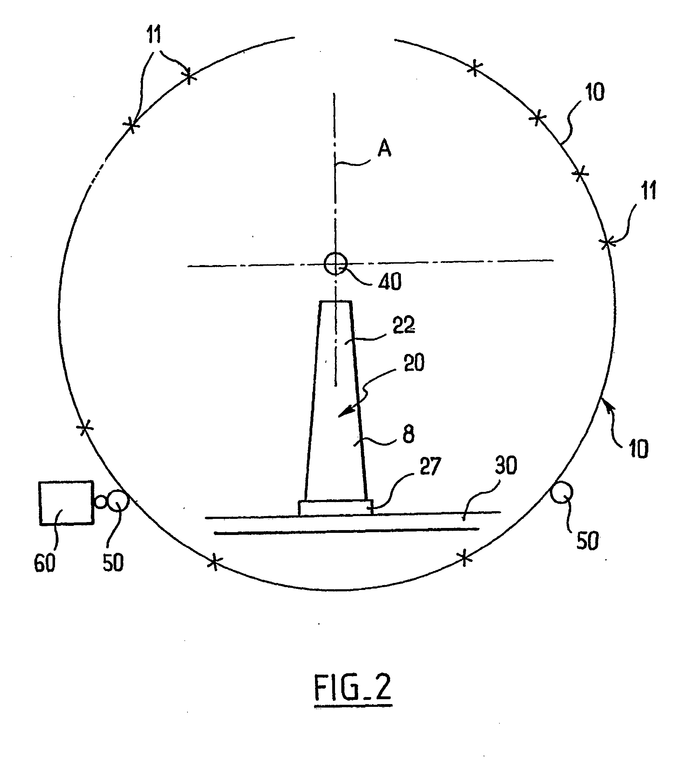

Un autre mode de réalisation est illustré sur la figure 2.

Dans ce mode de réalisation, le mat 20 est monté rotatif autour de son axe, tandis que l'arche 10 est montée sur des galets 50 l'autorisant à pivoter sur elle-même, dans son plan, autour du centre 40.

Une motorisation électrique 60 est prévue à cet effet pour déplacer l'arche sur elle-même avec un débattement angulaire d'au moins un pas angulaire.

Cette motorisation 60 permet bien entendu un mouvement dans un sens ou dans un autre.

On notera que dans l'une et/ou l'autre des deux variantes qui viennent d'être décrites, l'objet sous test peut lui-même être déplacé en translation perpendiculairement au plan du réseau de sondes de façon à permettre une mesure de champ en coordonnées cylindriques.

Des moyens peuvent être prévus spécifiquement au niveau du support pour guider l'objet sous test dans un déplacement perpendiculaire au plan du réseau.

Bien entendu, les dispositifs s'utilisent alors sans rotation autour de l'axe A.

Pour chaque position relative du réseau de sondes et de l'objet sous test, on réalise des acquisitions selon plusieurs positions de basculement relatif du réseau de sondes par rapport à l'objet sous test.

On obtient un résultat de mesure correspondant à une multiplication du nombre de points mesurés.

La structure proposée par l'invention permet là aussi un nombre supérieur de points de mesure par rapport au réseau de sondes utilisé, et par conséquent, des dimensions pour l'objet à mesurer ou des gammes de fréquences ou de longueurs d'onde de mesures plus importantes.

**Revendications**

1.  Dispositif pour la détermination d'au moins une caractéristique de rayonnement électromagnétique d'un objet sous test comprenant :

    - un support (20) présentant un axe principal (A) et destiné à recevoir ledit objet, et
    - un réseau de sondes (11) réparties sur une arche (10) sensiblement circulaire,

    **caractérisé en ce qu'**il comporte des moyens (25,26,60) autorisant le basculement du réseau de sondes (11) et du support (20) l'un par rapport à l'autre, dans le plan du réseau de sondes ou parallèlement à celui-ci,
    lesdits moyens étant configurés pour décaler angulairement le réseau de sondes (11) et l'axe principal (A) du support (20) l'un par rapport à l'autre dans ledit plan ou parallèlement à celui-ci, pour permettre ainsi des mesures selon plusieurs positions angulaires relatives du réseau de sondes (11) et de l'objet sous test.

2. Dispositif selon la revendication 1, **caractérisé en ce que** les moyens autorisant le basculement relatif du réseau de sondes (11) et du support comportent des moyens (20,26) aptes à basculer le support (20) par rapport au sol.

3. Dispositif selon l'une des revendications précédentes, **caractérisé en ce que** les moyens autorisant le basculement relatif du réseau de sondes et du support comportent des moyens (50,60) aptes à basculer le réseau de sondes (11) par rapport au sol.

4. Dispositif selon l'une des revendications précédentes, **caractérisé en ce que** les moyens de basculement relatif du réseau de sondes (11) et du support (20) sont aptes à permettre un décalage angulaire relatif du réseau de sondes (11) et du support (20) inférieur au pas angulaire du réseau de sondes.

5. Dispositif selon la revendication 4, **caractérisé en ce que** les moyens de basculement relatif du réseau de sondes (11) et du support (20) sont aptes à permettre un décalage angulaire relatif du réseau de sondes (11) et du support (20) correspondant à une fraction du pas angulaire du réseau de sondes (11).

6. Dispositif selon l'une des revendications précédentes, **caractérisé en ce que** les moyens de basculement relatif du réseau de sondes (11) et du support (20) sont aptes à permettre un décalage angulaire relatif du réseau de sondes (11) et du support (20) au moins égal au pas angulaire du réseau de sondes (11).

7. Dispositif selon l'une des revendications précédentes, **caractérisé en ce qu'**il est du type comportant des moyens aptes à entrainer en rotation relative le support (20) et l'arche (10) autour d'un axe de rotation principal sensiblement confondu avec un diamètre de celle-ci.

8. Dispositif selon l'une des revendications précédentes, **caractérisé en ce qu'**il est du type comportant des moyens aptes à déplacer l'objet sous test relativement au réseau de sondes (11) et perpendiculairement au plan de celui-ci.

9. Procédé pour la détermination d'au moins une caractéristique de rayonnement électromagnétique d'un objet sous test au moyen d'un dispositif comportant

un support (20) présentant un axe principal (A) et destiné à recevoir ledit objet, et
un réseau de sondes (11) réparti sur une arche (10) sensiblement circulaire,
dans lequel on positionne ledit objet sur ledit support (20) et on acquiert au moyen du réseau de sondes (11) une série de mesures correspondant à différentes positions de l'objet sous test par rapport audit réseau de sondes (11), **caractérisé en ce que** le dispositif est un dispositif selon l'une des revendications précédentes et **en ce qu'**on bascule le réseau de sondes (11) et l'axe principal (A) du support (20) l'un par rapport à l'autre, dans le plan du réseau de sondes ou parallèlement à celui-ci, pour réaliser des acquisitions selon plusieurs positions angulaires du réseau de sondes (11) par rapport à l'objet sous test.

10. Procédé selon la revendication 9, **caractérisé en ce que** le dispositif est un dispositif selon la revendication 7, **en ce qu'**on fait tourner l'arche (10) et/ou le support (20) en rotation autour de leur axe principal pour leur donner plusieurs positions relatives et **en ce que** pour chacune de ces positions de rotation, on bascule le réseau de sondes (11) et le support (20) relativement l'un par rapport à l'autre, dans le plan du réseau de sondes (11) ou parallèlement à celui-ci, pour réaliser des acquisitions selon plusieurs positions angulaires du réseau de sondes (11) par rapport à l'objet sous test.

11. Procédé selon la revendication 9, **caractérisé en ce que** le dispositif est un dispositif selon la revendication 8, **en ce qu'**on déplace l'arche (10) ou le support (20) perpendiculairement au plan de l'arche (10) pour leur donner plusieurs positions relatives et **en ce que** pour chacune de ces positions, on bascule le réseau de sondes (11) et le support (20) relativement l'un par rapport à l'autre, dans le plan du réseau de sondes (11) ou parallèlement à celui-ci, pour réaliser des acquisitions selon plusieurs positions angulaires du réseau de sondes (11) par rapport à l'objet sous test.

**Patentansprüche**

1. Vorrichtung zum Bestimmen mindestens einer Kenngröße der elektromagnetischen Strahlung eines Prüfobjekts, die Folgendes umfasst:

- einen Träger (20), der eine Hauptachse (A) aufweist und für die Aufnahme des Objekts bestimmt ist, und
- ein Netz von Sonden (11), die über einen im Wesentlichen kreisförmigen Bogen (10) verteilt sind,

**dadurch gekennzeichnet, dass** sie Mittel (25, 26, 60) aufweist, um das Verschwenken des Sondennetzes (11) und des Trägers (20) relativ zueinander in der Ebene des Sondennetzes oder parallel zu diesem zu gestatten, wobei die Mittel dafür eingerichtet sind, das Sondennetz (11) und die Hauptachse (A) des Trägers (20) relativ zueinander in der Ebene des Sondennetzes oder parallel zu diesem winklig zu versetzen, um dadurch Messungen in mehreren relativen Winkelpositionen des Sondennetzes (11) und des Prüfobjekts zu ermöglichen.

2. Vorrichtung nach Anspruch 1, **dadurch gekennzeichnet, dass** die Mittel, die das relative Verschwenken des Sondennetzes (11) und des Trägers gestatten, Mittel (20, 26) aufweisen, die dafür geeignet sind, den Träger (20) relativ zum Boden zu verschwenken.

3. Vorrichtung nach einem der vorhergehenden Ansprüche, **dadurch gekennzeichnet, dass** die Mittel, die das relative Verschwenken des Sondennetzes und des Trägers gestatten, Mittel (50, 60) aufweisen, die dafür geeignet sind, das Sondennetz (11) relativ zum Boden zu verschwenken.

4. Vorrichtung nach einem der vorhergehenden Ansprüche, **dadurch gekennzeichnet, dass** die Mittel zum relativen Verschwenken des Sondennetzes (11) und des Trägers (20) dafür geeignet sind, einen relativen Winkelversatz des Sondennetzes (11) und des Trägers (20) zu ermöglichen, der kleiner als der Winkelschritt des Sondennetzes ist.

5. Vorrichtung nach Anspruch 4, **dadurch gekennzeichnet, dass** die Mittel zum relativen Verschwenken des Sondennetzes (11) und des Trägers (20) dafür geeignet sind, einen relativen Winkelversatz des Sondennetzes (11) und des Trägers (20) zu ermöglichen, der einem Bruchteil des Winkelschritts des Sondennetzes (11) entspricht.

6. Vorrichtung nach einem der vorhergehenden Ansprüche, **dadurch gekennzeichnet, dass** die Mittel zum relativen Verschwenken des Sondennetzes (11) und des Trägers (20) dafür geeignet sind, einen relativen Winkelversatz des Sondennetzes (11) und des Trägers (20) zu ermöglichen, der mindestens gleich dem Winkelschritt des Sondennetzes (11) ist.

7. Vorrichtung nach einem der vorhergehenden Ansprüche, **dadurch gekennzeichnet, dass** sie des Typs ist, der Mittel aufweist, die dafür geeignet sind, den Träger (20) und den Bogen (10) in eine relative Drehung um eine Hauptdrehachse zu versetzen, die mit einem Durchmesser des Bogens im Wesentlichen zusammenfällt.

8. Vorrichtung nach einem der vorhergehenden Ansprüche, **dadurch gekennzeichnet, dass** sie des Typs ist, der Mittel aufweist, die dafür geeignet sind, das Prüfobjekt relativ zu dem Sondennetz (11) und senkrecht zu dessen Ebene zu bewegen.

9. Verfahren zum Bestimmen mindestens einer Kenngröße der elektromagnetischen Strahlung eines Prüfobjekts mittels einer Vorrichtung, die Folgendes umfasst:

   - einen Träger (20), der eine Hauptachse (A) aufweist und für die Aufnahme des Objekts bestimmt ist, und
   - ein Netz von Sonden (11), die über einen im Wesentlichen kreisförmigen Bogen (10) verteilt sind,

bei dem das Objekt auf dem Träger (20) positioniert wird und mittels des Sondennetzes (11) eine Reihe von Messungen erfasst wird, die verschiedenen Positionen des Prüfobjekts relativ zu dem Sondennetz (11) entsprechen, **dadurch gekennzeichnet, dass** die Vorrichtung eine Vorrichtung nach einem der vorhergehenden Ansprüche ist und dass das Sondennetz (11) und die Hauptachse (A) des Trägers (20) relativ zueinander, in der Ebene des Sondennetzes oder parallel zu diesem, verschwenkt werden, um Erfassungen in mehreren relativen Winkelpositionen des Sondennetzes (11) relativ zu dem Prüfobjekt realisieren.

10. Verfahren nach Anspruch 9, **dadurch gekennzeichnet, dass** die Vorrichtung eine Vorrichtung nach Anspruch 7 ist, dass der Bogen (10) und/oder der Träger (20) um ihre Hauptachse herum gedreht werden, um ihnen verschiedene relative Positionen zu verleihen, und dass für jede dieser Drehpositionen das Sondennetz (11) und der Träger (20) relativ zueinander, in der Ebene des Sondennetzes (11) oder parallel zu diesem, verschwenkt werden, um Erfassungen in mehreren relativen Winkelpositionen des Sondennetzes (11) relativ zu dem Prüfobjekt zu realisieren.

11. Verfahren nach Anspruch 9, **dadurch gekennzeichnet, dass** die Vorrichtung eine Vorrichtung nach Anspruch 8 ist, dass der Bogen (10) oder der Träger (20) senkrecht zu der Ebene des Bogens (10) bewegt werden, um ihnen verschiedene relative Positionen zu verleihen, und dass für jede dieser Positionen das Sondennetz (11) und der Träger (20) relativ zueinander, in der Ebene des Sondennetzes oder parallel zu diesem, verschwenkt werden, um Erfassungen in mehreren relativen Winkelpositionen des Sondennetzes (11) relativ zu dem Prüfobjekt zu realisieren.

## Claims

1. A device for determining at least one characteristic of electromagnetic radiation from an object under test that includes:

   a support (20) having a main axis (A) and intended to receive the said objet, and
   a network of probes (11) distributed over a substantially circular arc (10),
   **characterized in that** it includes means (25, 26, 60) that allow the tilting of the network of probes (11) and of the support (20) with respect to each other, in the plane of the network of probes or parallel thereto,
   said means being configured in order to angularly shift the network of probes (11) and the main axis (A) of the support (20) with respect to each other in said plane or parallel thereto, thus allowing measurements at several relative angular positions of the network of probes (11) and of the object under test.

2. The device according to claim 1, **characterized in that** the means which allow the relative tilting of the network of probes (11) and of the support include means (25, 26) capable of tilting the support (20) in relation to the ground.

3. The device according to one of the preceding claims, **characterized in that** the means that allow the relative tilting of the network of probes and of the support include means (50, 60) that are able to tilt the network of probes (11) in relation to the ground.

4. The device according to one of the preceding claims, **characterized in that** the relative tilting means of the network of probes (11) and of the support (20) are able to allow a relative angular shifting of the network of probes (11) and of the support (20) that is less than the angular pitch of the network of probes.

5. The device according to claim 4, **characterized in that** the relative tilting means (25, 26, 60) of the network of probes (11) and of the support (20) are able to allow a relative angular shifting of the network of probes (11) and of the support (20) corresponding to a fraction of the angular pitch of the network of probes (11).

6. The device according to one of the preceding claims, **characterized in that** the relative tilting means of the network of probes (11) and of the support (20) are able to allow a relative angular shifting of the network of probes (11) and of the support (20) at least equal to the angular pitch of the network of probes (11).

7. The device according to one of the preceding claims, **characterized in that** it is of the type that includes means that are able to drive the support (20) and the arc (10) in relative rotation around a main axis of rotation substantially merged with a diameter thereto.

8. The device according to one of the preceding claims, **characterized in that** it is of the type that includes means that are able to displace the object under test relatively to the network of probes (11) and perpendicularly to the plane thereto.

9. A method for determining at least one characteristic of electromagnetic radiation from an object under test by means of a device that includes:

   a support (20) having a main axis (A) and intended to receive the said objet, and
   a network of probes (11) distributed over a substantially circular arc (10),
   wherein the said objet is positioned on the said support (20), and the network of probes (11) is used to execute a series of measurements corresponding to different positions of the object under test in relation to the said network of probes (11), **characterized in that** the device is a device according to one of the preceding claims, and **in that** the network of probes (11) and the main axis (A) of the support (20) are tilted with respect to each other in the plane of the network of probes or parallel to the latter, in order to perform acquisitions at several angular positions of the network of probes (11) in relation to the object under test.

10. The method according to claim 9, **characterized in that** the device is a device according to claim 7, **in that** the arc (10) and/or the support (20) are driven in rotation around their main axis in order to place them in several relative positions, and **in that** for each of these positions of rotation, the network of probes (11) and the support (20) are tilted relatively with respect to each other in the plane of the network of probes (11) or parallel thereto, in order to perform acquisitions at several angular positions of the network of probes (11) with respect to the object under test.

11. The method according to claim 9, **characterized in that** the device is a device according to claim 8, **in that** the arc (10) or the support (20) are moved perpendicularly to the plane of the arc (10) in order to place them in several relative positions, and **in that** for each of these positions, the network of probes (11) and the support (20) are tilted with respect to each other in the plane of the network of probes (11) or parallel thereto, in order to perform acquisitions at several angular positions of the network of probes (11) with respect to the object under test.

**FIG_1**

FIG.2

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2797327

**Littérature non-brevet citée dans la description**

- **RUOSS et al.** EMC - investigation of hand-held mobile telephones using a double-cone nearfield to far-field transformation. *Proceedings of the European Microwave Conference, GB, Swanley, Nexus Media,* 1996, vol. 26, 795-798

- Spherical Near-Field Antenna Measurements, London: Peregrines. 1988